# EUROPEAN PATENT APPLICATION

(11) **EP 0 742 582 A2**
(43) Date of publication of application: **13.11.1996**
(21) Application number: 96303085.3
(22) Date of filing: 01.05.1996
(51) Int. Cl.: H01L 21/22

(54) **Doping procedure for semiconductor growth processes**

(30) Priority: 08.05.1995 US 436901
(71) Applicant: AT&T IPM Corp., Coral Gables, Florida 33134 (US)
(72) Inventor: Chiu, Tien-Heng, Spotswood, New Jersey 08884 (US); Williams, Michael D., Atlanta, Georgia 30314 (US); Curvello de Mendonca, Cesar Augusto, 13093-240 Campinas SD (BR)
(74) Representative: Johnston, Kenneth Graham

(57) **Abstract**

A method of growing doped semiconductor layers with controllable doping profiles is disclosed, whereby, segregation effects position the dopant atoms throughout the semiconductor material as it is grown. This method deposits an amount of dopant material, related to the thickness of the layer to be grown, on the substrate prior to material growth. During the crystal growth process, segregation effects position the dopant material throughout the semiconductor layer. The material growth temperature contributes to the movement of dopant atoms within the layer of material grown.

## Description

### Background of the Invention

### 1. Field of the Invention

The present invention is related to a method for manufacturing semiconductor materials, and more particularly to the doping of semiconductor layers.

### 2. Description of the Prior Art

The performance of any integrated circuit or optoelectronic device is dependent upon the precise control of doping profiles in the semiconductor materials used for their fabrication. Precise control of doping profiles improves electrical characteristics and permits a greater packing density of devices on the various types of substrates used. For example, with field effect transistors, precise confinement of the dopants in the doped material region improves such device characteristics as the cut-off voltage, gain and transconductance. Similarly, for semiconductor heterojunction lasers, precise confinement of the doping profile within the barrier layer improves various laser characteristics including the threshold current, power output and efficiency.

A difficulty encountered especially with respect to obtaining the desired doping profile is the inability to control the distribution of particular dopant atoms in the structure of the semiconductor material during crystal growth. For example, chromium doping can be used as a compensation technique, to increase the resistivity of buffer layers grown on many semiconductor materials. However, it is difficult to control the amount of chromium incorporated in the semiconductor material during crystal growth or to confine the dopant atom concentration so that it remains only within the buffer layer, thus eliminating any cross-layer contamination during subsequent material growth.

The amount of dopant material incorporated into the semiconductor material is difficult to control because there are inherent problems associated with the methods utilized in growth systems for providing the supply of dopant atoms to be incorporated into the semiconductor material. Confinement of the dopant atoms to the buffer layer is also difficult to achieve because segregation effects can rearrange the final distribution of dopant atoms contained in the semiconductor material. Segregation effects are important in material growth processes where varying dopant concentrations are present in a singular layer, and involves the migration of dopant atoms toward the top surface of a semiconductor material.

In chemical vapor deposition (CVD), or metal organic chemical vapor deposition (MOCVD) growth processes, dopant atoms are incorporated into the semiconductor material from a vapor stream. A known amount of dopant is added to the vapor stream to obtain the desired doping concentration in the crystal structure that is grown. During the material growth process, dopant atoms in the vapor stream are incorporated into the crystal and also get deposited on the walls inside of the reactor. As the growth process continues, dopant atoms from the walls of the reactor are returned to the vapor stream and as a result into the layer of material as it is grown. This second source of dopant material alters the desired concentration of dopant atoms that are incorporated into the semiconductor layer or contaminates subsequently grown layers of semiconductor material. Thus, this method of supplying dopant atoms for incorporation into a layer of semiconductor material, produces material with varying concentrations of dopant atoms,
which are also subject to possible segregation effects.

In molecular beam epitaxy, (MBE), which is another type of growth process, beams of dopant atoms are evaporated from a source and impinge directly upon the surface of the substrate at the same time as corresponding semiconductor constituents. The temperature of each source is controlled to give the desired evaporation rate. During material growth, dopant atoms are incorporated into the crystal structure, while at the same time cross-contaminating the sources of other material constituents. then in use. As the material layer continues to grow, the concentration of dopant atoms is altered through inclusion of the cross-contaminated material. As a result. this growth arrangement supplies additional dopant atoms during the growth process. making it difficult to control the amount of dopant that ultimately gets incorporated into the semiconductor layer. In addition, subsequently grown semiconductor layers can have the wrong dopants unintentionally included in their crystal structures. Therefore, this method of evaporating dopant atoms during the material growth process, for incorporation into a layer of semiconductor material, also produces a crystal structure containing varying concentrations of dopant atoms which are subject to segregation effects.

Thus, it would be useful to control the method by which dopant atoms are made available for incorporation into a semiconductor layer growth process and which also takes advantage of dopant segregation effects to distribute the dopant atoms in the semiconductor material as it is grown.

### Summary of the Invention

A method of semiconductor material growth with a controllable doping profile is disclosed. The method deposits an amount of dopant material on a substrate prior to material growth. The amount of dopant material deposited on the surface of the substrate is related to the thickness of the layer of semiconductor material to be grown and the segregation effects of the growth process. During the crystal growth process, segregation effects position the dopant atoms throughout the semiconductor material. The temperature during the growth process controls the movement of the dopant atoms in the layer of material grown.

### Brief Description of the Drawing

FIG. 1 shows a perspective view of an amount of dopant material deposited on the top surface of a substrate;
FIG. 2 shows this same view of the dopant material deposited on the surface of the substrate, in cross-section; and
FIG. 3 is the side view of the substrate and dopant material redistributed in the semiconductor layer after material growth.

### Detailed Description

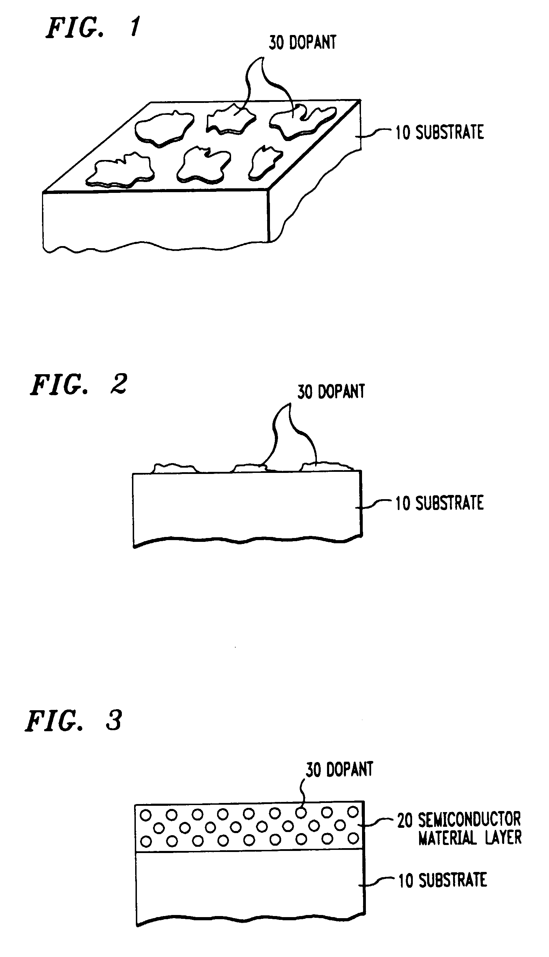

FIGS. 1-3 depict various stages of the disclosed method for growing uniformly doped semiconductor layers. The stages include the deposition of the dopant and semiconductor material growth steps. First, an amount of dopant 30 is deposited on a substrate 10, as illustrated in the depictions of FIGS. 1 and 2. The term "dopant", as used in the context of this disclosure, includes any element or atom which when incorporated into the structure of a semiconductor material, will alter the conductivity of the semiconductor material layer in which it is grown. The term "substrate", as used in the context of this disclosure, includes any material, of either a singular composition or having multiplelayers. Substrate 10 may be a semiconductor, metal or dielectric.

Dopant 30 may be a donor, an acceptor or semi-insulating. The term "donor", as used in the context of this disclosure, refers to an element that contributes a negative charge carrier to the conduction band of the semiconductor within which it is located. Typical examples of donor dopants include phosphorous, selenium, silicon, and tellurium. The term "acceptor", as used in the context of this disclosure, refers to an element that removes a negative charge carrier from the conduction band of the semiconductor material. Acceptor dopants which are commonly used include boron, cadmium and zinc. The term "semi-insulating", as used in the context of this disclosure, refers to dopants that inhibit the conduction capabilities of a material layer, by making them highly resistive. Dopants used to fabricate semi-insulating material include chromium and iron.

FIG. 1 shows a perspective view of dopant 30 deposited on the surface of substrate 10. Dopant 30 when deposited is a non-continuous layer, whose deposited amount is related to the thickness of the semiconductor layer to be grown and is typically on the order of a sub-monolayer. Another view of the deposition of dopant 30, as a noncontinuous layer on substrate 10, is illustrated in the cross-sectional depiction of FIG. 2. Dopant 30 may be placed on substrate 10 through the use of thermal evaporation, sputtering or any other conventional deposition technique.

The resultant structure is then completed with the growth of a layer of semiconductor material 20 on substrate 10, in which dopant 30 is incorporated. Semiconductor material layer 20 may be grown on substrate material 10 through the use of molecular beam epitaxy (MBE), liquid phase epitaxy (LPE), vapor phase epitaxy (VPE), metal organic chemical vapor deposition (MOCVD) or any other compatible growth technique. Distribution of dopant 30 within semiconductor material 20, occurs during the material growth process via segregation effects. The temperature at which semiconductor material layer 20 is grown, determines how dopant 30 will be distributed in the crystal structure. A cross-sectional view of substrate 10 and dopant 30, subsequent to the growth of semiconductor material layer 20 is shown in FIG. 3. An important aspect of the embodiment disclosed in FIGS. 1-3, is that dopant 30 is incorporated into the crystal structure of the semiconductor material that is grown through segregation effects.

Variations of the embodiment disclosed will be readily thought of by those skilled in the art.

## Claims

1. A method of growing a doped semiconductor layer comprising the steps of:
depositing a dopant (30) on a substrate (10); and
following the step of depositing, growing a layer of semiconductor material (20) on said dopant and said substrate.

2. The method of claim 1, in which segregation effects position said dopant within said layer of semiconductor material during the crystal growth step.

3. The method of claim 1, in which the amount of said dopant (30) deposited on said substrate (10) is related to the thickness of said layer of semiconductor material (20) to be grown.

4. The method of claim 1, in which the amount of said dopant (30)deposited on said substrate (10) is a sub-monolayer of material.

5. The method of claim 1, in which the growth of said layer of semiconductor material (20) is conducted at a temperature greater than 200 °C.

6. The method of claim 1, in which said dopant (30) is chromium.
